# EUROPEAN PATENT SPECIFICATION

(11) **EP 2 787 537 B1**
(45) Date of publication and mention of the grant of the patent: **20.07.2016**
(21) Application number: 12853469.0
(22) Date of filing: 30.11.2012
(51) Int. Cl.: H01L 31/032, H01L 31/0749, H01L 31/18

(54) **THIN FILM SOLAR CELL with indium sulfide buffer layer**
DÜNNSCHICHTSOLARZELLE mit Pufferschicht aus Indiumsulfid
CELLULE SOLAIRE EN COUCHES MINCES avec couche tampon à sulfure d'indium

(30) Priority: 02.12.2011 JP 2011264652
(43) Date of publication of application: 08.10.2014
(73) Proprietor: Solar Frontier K.K., Minato-ku Tokyo 135-8074 (JP)
(72) Inventor: SUGIMOTO, Hiroki, Tokyo 135-8074 (JP); SAKAI, Noriyuki, Tokyo 135-8074 (JP); HIROI, Homare, Tokyo 135-8074 (JP)
(74) Representative: Hoffmann Eitle
(86) International application number: PCT/JP2012/081105
(87) International publication number: WO 2013/081114

(56) References cited:
- WO-A2-2010/023264
- JP-A- 2007 317 885
- JP-A- 2011 165 900
- HARISKOS D ET AL: "A novel cadmium free buffer layer for Cu(In,Ga)Se2 based solar cells", SOLAR ENERGY MATERIALS AND SOLAR CELLS, ELSEVIER SCIENCE PUBLISHERS, AMSTERDAM, NL, vol. 41-42, 1 June 1996 (1996-06-01), pages 345-353, XP004007953, ISSN: 0927-0248, DOI: 10.1016/0927-0248(96)80009-2
- WEBER M ET AL: "THE ROLE OF THE INTERFACE OXIDATION FOR THE IMPROVEMENT OF CuInS2 THIN-FILM SOLAR CELLS", 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICS SPECIALISTS CONFERENCE. / 10TH ASIA/PACIFIC PV SCIENCE AND ENGINEERING CONFERENCE. JULY 6 - 10, 1998, 6 July 1998 (1998-07-06), pages 565-568, XP001140580, ISBN: 978-92-828-5179-1
- RAJESHMON V G ET AL: "Role of precursor solution in controlling the opto-electronic properties of spray pyrolysed Cu2ZnSnS4 thin films", SOLAR ENERGY, PERGAMON PRESS. OXFORD, GB, vol. 85, no. 2, 3 January 2011 (2011-01-03), pages 249-255, XP027599073, ISSN: 0038-092X, DOI: 10.1016/J.SOLENER.2010.12.005 [retrieved on 2011-01-12]

## Description

### Technical Field

The present invention relates to a thin film solar cell, in particular, relates to a thin film solar cell which can achieve a high photovoltaic conversion efficiency.

### Background Art

In recent years, thin-film solar cells using a Group I-III-VI₂ compound semiconductor or Group I₂-(II-IV)-VI₄ compound semiconductor as a p-type light absorption layer have come under the spotlight. Among these, ones which use a chalcogenide structure Group I-III-VI₂ compound semiconductor which contains Cu, In, Ga, Se, or S are called "CIS-based thin-film solar cells". As typical materials, there are Cu(In, Ga)Se₂, Cu(In, Ga) (Se, S)₂, CuInS₂, etc.

Further, ones which use a chalcogenide based Group I₂-(II-IV)-VI₄ compound semiconductor which contains Cu, Zn, Sn, S, or Se as a p-type light absorption layer are called "CZTS-based thin-film solar cells". As typical ones, there are Cu₂ZnSnS₄, Cu₂ZnSnSe₄, Cu₂ZnSn(S, Se)₄, etc.

These thin-film solar cells use materials which can be easily obtained at relatively low cost, are relatively easy in method of production, and have large coefficients of absorption from the visible to near infrared wavelength range, so promise high photovoltaic conversion efficiency and so are considered as promising candidates for next generation type solar cells.

However, the photovoltaic conversion efficiency which is currently being realized in these thin-film solar cells is considerably lower than the theoretical value, therefore, there is room for great improvement in the method of production. In particular, in CZTS-based thin-film solar cells, products which have a high photovoltaic conversion efficiency which are able to withstand practical use have not yet been obtained. Further progress in production technology is being sought. Note that, the general structure and method of production of CIS-based thin-film solar cells are disclosed in PLT 1, while CZTS-based thin-film solar cells are disclosed in PLT 2.

A fabrication method for a thin-film solar cell comprising a CIS-based light absorption layer and an InS-based buffer layer is disclosed in Hariskos D. et al: "A novel cadmium free buffer layer for Cu(ln,Ga)Se2 based solar cells", Solar Energy Materials and Solar Cells, vol. 41-42, p. 345-353.

### Citations List

### Patent Literature

PLT 1. Japanese Patent Publication No. 2006-165386A
PLT 2. Japanese Patent Publication No. 2010-215497A

### Summary of Invention

### Technical Problem

The present invention was made for the purpose of solving the above problem in a CIS-based thin-film solar cell or CZTS-based thin-film solar cell and has as its object the provision of a novel method of production which enables the photovoltaic conversion efficiency to be increased.

### Solution to Problem

To solve this problem, the thin-film solar cell of the present invention is produced by a method according to claim 1 by forming a metal back electrode layer on a substrate, forming a p-type light absorption layer on the metal back electrode layer, oxidizing the p-type light absorption layer surface by annealing in the atmosphere forming an InS-based buffer layer as an n-type high resistance buffer layer on the oxidized p-type light absorption layer, and forming an n-type transparent conductive film on the InS-based buffer layer.

In this method of production, the p-type light absorption layer surface is oxidized by annealing in the atmosphere. Further, the InS-based buffer layer may be formed by a chemical bath deposition method (CBD).

Furthermore, the p-type light absorption layer may be formed by a CZTS-based semiconductor. Further, the p-type light absorption layer may be formed by CIS or a CIGS-based semiconductor.

### Advantageous Effects of Invention

The p-type light absorption layer is for example annealed in the atmosphere to form an oxide film on the surface, then, for example, chemical bath deposition is used to form an InS-based buffer layer. In the process of the chemical bath deposition, the oxygen from the oxide film on the p-type light absorption layer diffuses in the formed InS-based buffer layer whereupon an oxide film of In is formed at the junction with the p-type light absorption layer. An oxide of In has a wider bandgap than a sulfide of In, so at the junction, the amount of conduction band discontinuity accompanying hetero junction with the p-type light absorption layer is increased. As a result, the leak current is suppressed and the solar cell is improved in fill factor and open-circuit voltage.

Furthermore, as the buffer layer, from the viewpoint of the transmission of light, a material with a wide bandgap is preferable. In the method of production of the present invention, an In oxide layer with a broader bandgap than In sulfide is formed at the junction, so the transmission of light is improved and the short-circuit current density is increased. Due to the improvement in the fill factor, open-circuit voltage, and short-circuit current density, the photovoltaic conversion efficiency is greatly improved.

Note that, in a conventional thin-film solar cell using a CdS-based or ZnS-based buffer layer, if the p-type light absorption layer has an oxide film on it, the amount of conduction band discontinuity will fall and the leak current will increase, so the presence of an oxide film is taboo. After removal by etching, a step of forming a buffer layer was performed. In the method of the present invention, the presence of the oxide film rather improves the properties of the solar cell, so the etching step becomes unnecessary and the process of production is simplified.

### Brief Description of Drawings

FIG. 1 is a cross-sectional view which shows the general schematic structure of a CZTS-based thin-film solar cell.
FIG. 2 is an energy band diagram which is used for explaining the advantageous effects of the present invention.
FIG. 3A is a view for explaining the method of production according to the present invention and shows the step before forming an n-type high resistance buffer layer on a p-type CZTS-based light absorption layer.
FIG. 3B is a view which shows the step after the step which is shown in FIG. 3A.

### Description of Embodiments

Below, various embodiments of the present invention will be explained with reference to the drawings. Note that, in the following drawings, what are described as schematic views facilitate understanding by showing the thicknesses of the layers by a relationship different from the actual one. Further, in the figures, the same reference numerals show the same or similar component elements. Furthermore, below, the present invention will be explained using a CZTS-based thin-film solar cell as an example, but the present invention is not limited to only the method of production of a CZTS-based thin-film solar cell and can also be applied to a method of production of a CIS-based thin-film solar cell of a chalcogenide semiconductor which has a similar composition of course.

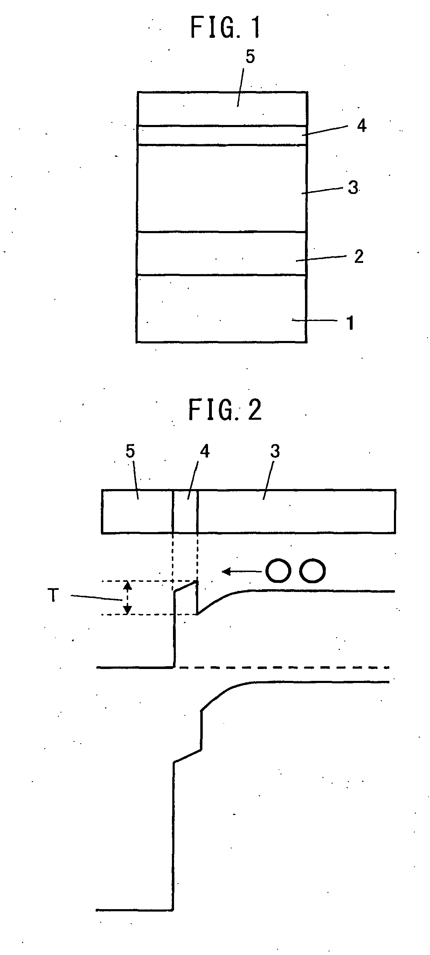

FIG. 1 is a cross-sectional view which shows the general schematic structure of a CZTS-based thin-film solar cell 10. In the figure, 1 indicates a glass substrate, 2 a metal back electrode layer which is made using Mo or another metal as a material, 3 a p-type CZTS-based light absorption layer (below, p-type light absorption layer), 4 an n-type high resistance buffer layer, and 5 an n-type transparent conductive film. The p-type light absorption layer 3 is, for example, formed by successively forming Cu, Zn, and Sn on the metal back electrode layer 2 by electron beam deposition etc. to form a metal precursor film and sulfurizing or selenizing the same.

An n-type high resistance buffer layer 4 is generally a thin film of a compound which contains Cd, Zn, and In (film thickness of 3 nm to 50 nm or so). As typical materials, there are CdS, ZnS, and In₂S₃. Note that, usually, these buffer layers are generally formed by a chemical bath deposition method (CBD). A base material is dipped in a solution which contains the chemical species which forms the "CBD" precursor and a heterogeneous reaction is caused between the solution and base material surface to deposit a thin film on the base material. For this reason, the formed n-type high resistance buffer layer 4 is not purely CdS, ZnS, or In₂S₃, but includes O and OH. Such a buffer layer is called a CdS-based buffer layer, ZnS-based buffer layer, or InS-based buffer layer.

In a CIS-based thin-film solar cell or CZTS-based thin-film solar cell, there is the problem that an InS-based buffer layer has a lower height of conduction band discontinuity accompanying the hetero junction with the p-type light absorption layer and a larger leak current compared with a CdS-based buffer layer or a ZnS-based buffer layer. For this reason, in general, as an n-type high resistance buffer layer 4, a CdS-based buffer layer or ZnS-based buffer layer is used.

Note that, an n-type high resistance buffer layer 4 can be formed not only by CBD, but also, as a dry process, by metal organic chemical vapor deposition (MOCVD) or atomic layer deposition (ALD).

An n-type transparent conductive film 5 is formed by an n-type conductivity, broad bandgap, transparent, and low resistance material to a film thickness of 0.05 to 2.5 µm. Typically, there is a zinc oxide-based thin film (ZnO) or ITO thin film. In the case of a ZnO film, a Group III element (for example Al, Ga, B) is added as a dopant to obtain a low resistance film. The n-type transparent conductive film 5 can be formed by not only MOCVD, but also sputtering (DC, RF) etc.

In the conventional method of production of a CZTS-based thin-film solar cell, before forming the n-type high resistance buffer layer 4, ammonia or another etching gas is used to etch the surface of the p-type light absorption layer 3, then, for example, a chemical bath deposition method or the like is used to grow a CdS-based buffer layer or ZnS-based buffer layer. This is so as to remove the oxide film which was formed on the surface of the p-type light absorption layer 3 surface before forming the buffer layer.

If there is an oxide film at the surface which forms the buffer layer, in the case of a CdS-based buffer layer, CdO is formed at the junction while in the case of a ZnS-based buffer layer, ZnO is formed. This is because the oxygen in the oxide film diffuses in the buffer layer and bonds with the Cd or Zn. In the case of a CdS-based buffer layer, the bandgap of CdS is 2.4eV, while that of CdO is 2.1eV, while in the case of a ZnS-based buffer layer, the bandgap of ZnS is 3.6eV, while that of ZnO is 3.4eV. In each case, the oxide has a narrower bandgap than a sulfide. Therefore, if forming on the p-type light absorption layer 3 an n-type high resistance buffer layer 4 while leaving an oxide film, a layer with a narrow bandgap is formed at the junction, the amount of conduction band discontinuity accompanying the hetero junction becomes smaller, the leak current is increased, and other problems arise.

FIG. 2 shows an energy band diagram of the vicinity of the junction of the p-type light absorption layer 3 of the CZTS-based thin-film solar cell and the n-type high resistance buffer layer 4. In a preferable solar cell, at the hetero junction of the p-type light absorption layer 3 and the n-type high resistance buffer layer 4, a certain degree of amount of conduction band discontinuity is designed to be secured. If the amount of discontinuity T is small, problems arise such as an increase in the leak current. When providing a CdS-based buffer layer 4 at the p-type light absorption layer 3, this amount of discontinuity T is 0.2 to 0.3eV, preferably a value sufficient for obtaining a solar cell. In the case of a ZnS-based buffer layer as well, a sufficient amount of discontinuity T can be secured.

In this regard, if a CdO or ZnO or other oxide film with a bandgap which is smaller than a sulfide is formed at the interface of the buffer layer 4 and the p-type light absorption layer 3, the amount of discontinuity T decreases and problems are caused. Therefore, to eliminate the formation of such an oxide film, it is necessary to remove the oxide film which is formed on the surface of the p-type light absorption layer 3 by etching etc. in advance.

The inventors of the present invention noticed while searching for a desirable n-type high resistance buffer layer material that the situation completely differs compared with use of an InS-based buffer. In the case of an InS-based buffer, the bandgap of In₂S₃ is 2.7eV, while the bandgap of In₂O₃ is 3.6eV. An oxide has a considerably larger bandgap than a sulfide. Therefore, it was thought that if it were possible to utilize this property well, the InS-based buffer layer could be utilized to realize a solar cell with a high photovoltaic conversion efficiency.

An InS-based buffer layer has a smaller amount of discontinuity T and larger leak current compared with the CdS-based buffer layer and ZnS-based buffer layer, so is not being utilized much as a buffer layer of a CIS-based or CZTS-based thin-film solar cell. However, as explained above, the bandgap of In₂O₃ is 3.6eV or considerably broader than the bandgap of In₂S₃ of 2.7eV. Therefore, the inventors thought that if deliberately interposing an In₂O₃ layer between the p-type light absorption layer 3 and the InS-based buffer layer, the amount of discontinuity T of the conduction band accompanying hetero junction with the light absorption layer would become larger and leak current might be able to be suppressed. In this case, they expected that it would possible to use the InS-based buffer layer as an n-type high resistance buffer layer of a CIS-based or CZTS-based thin-film solar cell and thereby obtain a high photovoltaic conversion efficiency.

Therefore, the inventors thought to, conversely to the conventional method of production, deliberately form an oxide layer on the p-type light absorption layer 3 to promote the formation of an In₂O₃ film in the subsequent process of formation of the InS-based buffer layer. This is because they expected that by forming an In₂O₃ film, it would be possible to increase the amount of discontinuity T of the conduction band accompanying the hetero junction with the light absorption layer and suppress leak current and thereby improve the fill factor (FF) and open-circuit voltage (Voc).

Furthermore, as the buffer layer, from the viewpoint of the transmission of light, a material with a wide bandgap is preferable, but they expected that in the case of an InS-based buffer, an In₂O₃ film might be introduced to make the bandgap of the buffer layer broader and thereby improve the short-circuit current density Jsc.

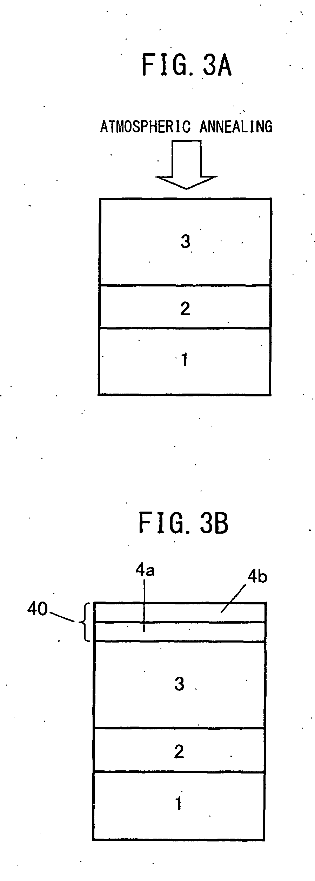

FIGS. 3A and 3B schematically show a method of production according to the present invention. As shown in FIG. 3A, the metal back electrode layer 2 is formed with a p-type light absorption layer 3, then this is annealed in the atmosphere to form an oxide film (not shown) on the surface of the p-type light absorption layer 3. Next, as shown in FIG. 3B, as usual, CBD is performed to form an InS-based buffer layer 40. At this time, the p-type light absorption layer 3 is formed with an oxide film on it by atmospheric annealing, so at the initial stage of CBD treatment, the precursor species constituted by the In ions reacts with the oxide film to easily form In₂O₃ whereby an In₂O₃ rich layer 4a is formed. If the CBD treatment progresses, In₂S₃ easily forms and an In₂S₃ rich layer 4b is formed.

After an InS-based buffer layer 40 which includes an In₂O₃ rich layer 4a and In₂S₃ rich layer 4b is formed, an n-type transparent conductive film 5 (see FIG. 1) is formed over it to obtain a solar cell.

The following Table 1 shows the results of experiments which were run to verify the advantageous effects of the method of production which is shown in FIG. 3. Sample 1 of this experiment is a CZTS-based thin-film solar cell which is formed with an InS-based buffer layer by direct CBD treatment without atmospheric annealing of the p-type light absorption layer. Sample 2 is a CZTS-based thin-film solar cell which is formed with an InS-based buffer layer by CBD treatment after atmospheric annealing. These samples were measured for values of photovoltaic conversion efficiency (Eff), open-circuit voltage Voc, short-circuit current density Jsc, and fill factor (FF). Note that, in Sample 2, the atmospheric annealing was conducted at an atmospheric temperature of 130°C for about 30 minutes.

**Table 1**

| | Annealing | Eff (%) | Voc (mV) | Jsc (mA/cm²) | FF |
|---|---|---|---|---|---|
| Sample 1 | No | 4.83 | 586 | 17.12 | 0.481 |
| Sample 2 | Yes | 5.61 | 608 | 17.08 | 0.535 |

| | | | | | |
|---|---|---|---|---|---|
| (Atmospheric annealing: 130°C, 30 minutes) | | | | | |

Sample 2 where atmospheric annealing was performed before CBD treatment was greatly improved in open-circuit voltage Voc and fill factor FF compared with Sample 1 where it was not performed. A high photovoltaic conversion efficiency Eff could be obtained. This is believed to be because in the case of an InS-based buffer, an oxide film is formed on the p-type light absorption layer 3 before CBD treatment whereby there is the effect of the InS-based buffer layer becoming In₂O₃ rich at the side bonded to the light absorption layer.

Table 2 shown below shows the results of experiments which were run for verifying the effects of the temperature of the annealing performed before the CBD treatment. In Sample 3, the temperature of the atmospheric annealing was made 130°C, in Sample 4, 180°C and in Sample 5, 250°C. In each sample, the annealing time was 30 minutes. After atmospheric annealing of the p-type light absorption layer 3, each sample was formed with an InS-based buffer layer by CBD treatment.

**Table 2**

| | Annealing | Eff (%) | Voc (mV) | Jsc (mA/cm²) | FF |
|---|---|---|---|---|---|
| Sample 3 | 130°C | 5.78 | 638 | 17.33 | 0.523 |
| Sample 4 | 180°C | 6.34 | 653 | 18.33 | 0.530 |
| Sample 5 | 250°C | 6.00 | 627 | 17.64 | 0.543 |

| | | | | | |
|---|---|---|---|---|---|
| (Atmospheric annealing time, 30 minutes) | | | | | |

Sample 4 where annealing was performed at 180°C before the CBD treatment and Sample 5 where annealing was performed at 250°C, compared with Sample 3 where annealing was performed at 130°C, have a higher photovoltaic conversion efficiency Eff. From this, it is believed that sufficient oxidation of a p-type light absorption layer at a relatively high annealing temperature leads to an improvement in the photovoltaic conversion efficiency.

Note that, in Sample 2 to Sample 5, as the method of forming the oxide film on the p-type light absorption layer 3, annealing in the atmosphere was employed, but the present invention is not limited to this. It may also be annealing in an oxygen-containing atmosphere.

The following Table 3 summarizes the compositions and methods of formation of the different parts of the thin-film solar cells of Samples 1 to 5. Note that, the atmospheric annealing step of the p-type light absorption layer was already explained using Table 1, Table 2, and FIG. 3, so will be omitted in Table 3.

**Table 3**

| Substrate 1 | Glass substrate | |
|---|---|---|
| Metal back electrode layer 2 | Composition | Mo |
| | Film thickness | 200 to 500 nm |
| | Deposition method | DC sputtering |
| | Deposition pressure | 0.5 to 2.5 Pa |
| | Deposition power | 1.0 to 3.0W/cm² |
| Metal precursor film | Composition | ZnS, Sn, and Cu successively formed on Mo |
| | Deposition method | Electron beam deposition |
| Sulfurization | Atmosphere | Hydrogen sulfide-containing gas |
| | Time | 0.1 to 3H |
| | Temperature | 500 to 650°C |
| p-type light absorption layer 3 | Composition | Cu₂ZnSnS₄ |
| | Film thickness | About 0.5 to 2 µm |
| n-type high resistance buffer layer 4 | Composition | In₂(S,O,OH)₃ |
| | Film thickness | 3 to 50 nm |
| | Deposition method | Chemical bath deposition (CBD) |
| n-type transparent conductive film 5 | Composition | BZO (boron-doped ZnO) |
| | Film thickness | 0.5 to 2.5 µm |
| | Deposition method | MOCVD |

Note that, Samples 1 to 5 have p-type light absorption layers 3 of a composition of Cu₂ZnSnS₄, but the present invention is not limited to this. It is clear that even with Cu₂ZnSnSe₄ or Cu₂ZnSn(S, Se)₄, a similar effect can be obtained. Furthermore, a metal precursor film for forming the p-type light absorption layer 3 may also use Zn instead of the ZnS which is shown in Table 3 and may use SnS instead of Sn. Furthermore, in addition to successively forming films of Zn, Sn, and Cu, it is possible to use a deposition source obtained by prealloying two or three of Zn, Sn, and Cu or a deposition source which is comprised of a selenide and/or sulfide of the same. As the deposition method, in addition to EB deposition, simultaneous deposition or sputtering may be used.

Furthermore, the substrate 1, metal back electrode layer 2, n-type high resistance buffer layer 4, and n-type transparent conductive film 5 are also not limited to the case which is described in Table 3. For example, as the substrate 1, in addition to blue sheet glass, low alkali glass, or other glass substrate, a stainless steel sheet or other metal substrate, polyimide resin substrate, etc. may be used. As the method of forming a metal back electrode layer 2, in addition to the DC sputtering which is described in Table 2, there is electron beam deposition, atomic layer deposition (ALD), etc. As the material of the metal back electrode layer 2, a high corrosion resistance and high melting point metal, for example, chromium (Cr), titanium (Ti), etc. may be used.

Furthermore, even if using a CIS-based semiconductor or CIGS-based semiconductor instead of a CZTS-based semiconductor as a light absorption layer, it is of course possible to expect similar effects.

The experiments which are shown in the above Table 1 to Table 3 were run on solar cells which have light absorption layers formed by p-type CZTS-based light absorption layers. However, both CIS-based (or CIGS-based) thin-film solar cells and CZTS-based thin-film solar cells use sulfide semiconductors which have similar compositions as light absorption layers, so even in the case of CIS-based thin-film solar cells, in the same way as CZTS-based thin-film solar cells, oxidation of the light absorption layer before formation of the InS-based buffer layer is effective for improvement of the photovoltaic conversion efficiency.

### Reference Signs List

- 1: substrate
- 2: metal back electrode layer
- 3: p-type light absorption layer
- 4: n-type high resistance buffer layer
- 4a: In₂O₃ rich layer
- 4b: In₂S₃ rich layer
- 5: n-type transparent conductive film
- 40: InS-based buffer layer

## Claims

1. A method of production of a thin-film solar cell which comprises:
(i) forming a metal back electrode layer (2) on a substrate (1),
(ii) forming a p-type light absorption layer (3) on the metal back electrode layer (2),
(iii) oxidizing the surface of the layer (3) by annealing the layer (3) in the atmosphere,
(iv) forming an InS-based buffer layer as an n-type high resistance buffer layer (4) on the oxidized layer (3), and
(v) forming an n-type transparent conductive film (5) on the InS-based buffer layer.

2. The method of claim 1, wherein the InS-based buffer layer is formed by a chemical bath deposition method (CBD).

3. The method of claim 1 or 2, wherein the layer (3) is formed by a CZTS-based semiconductor.

4. The method of claim 1 or 2, wherein the layer (3) is formed by CIS or a CIGS-based semiconductor.

## Patentansprüche

1. Verfahren zur Herstellung einer Dünnfilm-Solarzelle, welche umfasst:
(i) Bilden einer Metall-Rückelektrodenschicht (2) auf einem Substrat (1),
(ii) Bilden einer Lichtabsorptionsschicht (3) vom p-Typ auf der Metall-Rückelektrodenschicht (2),
(iii) Oxidieren der Oberfläche der Schicht (3) durch Wärmebehandeln der Schicht (3) in der Atmosphäre,
(iv) Bilden einer InS-basierten Pufferschicht als Pufferschicht mit hohem Widerstand vom n-Typ (4) auf der oxidierten Schicht (3), und
(v) Bilden eines transparenten, leitfähigen Films vom n-Typ (5) auf der InS-basierten Pufferschicht.

2. Verfahren gemäß Anspruch 1, worin die InS-basierte Pufferschicht durch ein Verfahren durch Abscheidung in einem chemischen Bad (CBD) gebildet ist.

3. Verfahren gemäß Anspruch 1 oder 2, worin die Schicht (3) durch einen CZTS-basierten Halbleiter gebildet wird.

4. Verfahren gemäß Anspruch 1 oder 2, worin die Schicht (3) durch CIS- oder einen CIGS-basierten Halbleiter gebildet wird.

## Revendications

1. Procédé de production d'une pile solaire à couche mince, comprenant :
(i) la formation d'une couche d'électrode métallique arrière (2) sur un substrat (1),
(ii) la formation d'une couche d'absorption de lumière de type p (3) sur la couche d'électrode métallique arrière (2),
(iii) l'oxydation de la surface de la couche (3) par le recuit de la couche (3) dans l'atmosphère,
(iv) la formation d'une couche tampon à base d'InS sous la forme d'une couche tampon à haute résistance de type n (4) sur la couche (3) oxydée, et
(v) la formation d'un film conducteur transparent de type n (5) sur la couche tampon à base d'InS.

2. Procédé selon la revendication 1, dans lequel la couche tampon à base d'InS est formée par un procédé de dépôt en bain chimique (CBD).

3. Procédé selon la revendication 1 ou 2, dans lequel la couche (3) est formée par un semi-conducteur à base de CZTS.

4. Procédé selon la revendication 1 ou 2, dans lequel la couche (3) est formée par un semi-conducteur à base de CIS ou de CIGS.
